# EUROPEAN PATENT APPLICATION

(11) **EP 1 970 958 A2**
(43) Date of publication of application: **17.09.2008**
(21) Application number: 08250579.3
(22) Date of filing: 19.02.2008
(51) Int. Cl.: H01L 27/12, H01L 21/77, H01L 27/13

(54) **Organic light emitting display and method for manufacturing the same**

(30) Priority: 16.03.2007 KR 20070026198
(71) Applicant: Samsung SDI Co., Ltd., Suwon-si, Gyeonggi-do (KR)
(72) Inventor: Shin, Hye-Jin, c/o Samsung SDI Co. Ltd., Suwon-si, Gyeonggi-do (KR)
(74) Representative: Mounteney, Simon James

(57) **Abstract**

An organic light emitting display capable of reducing or preventing damage due to static electricity by using a structure for reducing or preventing the damage due to static electricity and a method for manufacturing the same. A pixel region includes a plurality of data lines, a plurality of scan lines, and a plurality of pixels, the data lines crossing the scan lines, and the pixels being coupled to the data lines and the scan lines. A data driver is coupled to the data lines and transfers a data signal. A scan driver is coupled to the scan lines and transfers a scan signal. A discharge capacitor unit is located at a connection region between the pixel region and the scan driver.

## Description

### BACKGROUND

### 1. Field of the Invention

The present invention relates to an organic light emitting display and a method of manufacturing the same.

### 2. Discussion of Related Art

Organic light emitting display devices having high emission efficiency, brightness, viewing angles, and response speed are in the spotlight. Organic light emitting displays express images using a plurality of organic light emitting diodes (OLEDs). An OLED includes an anode electrode, a cathode electrode, and an organic emission layer positioned between the anode electrode and the cathode electrode to emit light by combination of electrons and holes.

The organic light emitting display mentioned above adjusts the amount of an electric current through the OLEDs to express a gradation (or grayscale) in such a way that it expresses high luminance when the electric current amount is large and low luminance when the electric current amount is small.

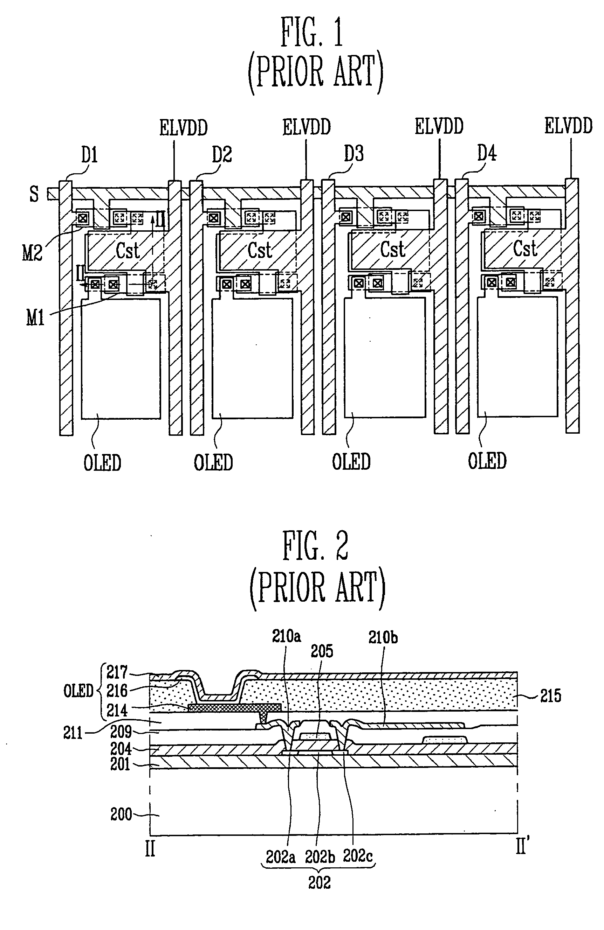

FIG. 1 is a layout showing a part of a pixel region in a conventional organic light emitting display. With reference to FIG. 1, four pixels are arranged in the form of 4×1, each having the same construction.

A first transistor M1 and a second transistor M2 are formed on a substrate. A first electrode of a storage capacitor Cst is formed between the first transistor M1 and the second transistor M2. The first electrode of the storage capacitor Cst is coupled to a gate electrode of the first transistor M1 and a drain electrode of the second transistor M2. Further, a drain electrode of the first transistor M 1 is coupled to an anode electrode of the organic light emitting diode OLED.

A first scan line S is arranged in a horizontal direction, and is coupled to a gate electrode of the second transistor M2. A first data line D1 and the first power supply line ELVDD are formed vertically to cross the scan line S.

Moreover, a second electrode of the storage capacitor Cst is formed at a position facing a first electrode of the storage capacitor Cst, and is coupled to a pixel power supply line ELVDD and a source electrode of the first transistor M1.

FIG. 2 is a cross-sectional view of the organic light emitting display taken along line II-II' of FIG. 1. With reference to FIG. 2, a buffer layer 201 is formed on a substrate 200, and an active layer 202 is formed on the buffer layer 201 in an island pattern. The active layer 202 is made of poly-silicon. A first insulation film 204 is formed on the buffer layer 201 and the active layer 202. A gate metal 205 is patterned on the first insulation film 204.

Also, a second insulation film 209 is formed on the first insulation film 204 and the gate metal 205. Contract holes are formed at the first insulation film 204 and the second insulation film 209. Source-drain metals 210a and 210b contact with the active layer 202 through the respective contact holes, so that a source 202c, a drain 202a, and a channel 202b are formed at the active layer 202. Also, a third insulation film 211 is formed on the second insulation film 209 and the source-drain metals 210a and 210b, and an upper portion of the third insulation film 211 is patterned. Further, an anode electrode 214 is patterned on the third insulation film 211. A contact hole is formed at the third insulation film 211, and the anode electrode 214 contacts with the source-drain metals 210a and 210b through the contact hole. A pixel definition layer (PDL) 215 and an emission layer 216 are formed on the third insulation film 211 and the anode electrode 214, and a cathode electrode 217 is formed thereon.

In the conventional organic light emitting display constructed above, externally generated static electricity can be transferred to the inside of the organic light emitting display. Since static electricity has a high voltage, when it is transferred to a scan line, transistors included in a pixel are damaged, thereby incurring a defect of the pixel. This causes the organic light emitting display not to be used.

### SUMMARY OF THE INVENTION

Embodiments of the present invention, set out to provide an organic light emitting display capable of reducing or preventing damage due to static electricity by using a structure for reducing or preventing the damage due to the static electricity, and a method for manufacturing the same.

Accordingly, a first aspect of the present invention provides an organic light emitting display comprising: a pixel region including a plurality of data lines, a plurality of scan lines, and a plurality of pixels, the plurality of data lines crossing the plurality of scan lines, and the pixels being coupled to the data lines and the scan lines; a data driver coupled to the data lines for transferring a data signal; a scan driver coupled to the scan lines for transferring a scan signal; and a discharge capacitor unit at a connection region between the pixel region and the scan driver.

Preferred features of this aspect of the invention are set out in Claims 2 and 3.

According to a second aspect of the present invention, there is provided a method for driving an organic light emitting display, the method comprising: forming a poly-silicon layer on a substrate to form a first electrode of a discharge capacitor when an active layer of a transistor is formed; and forming a metal layer to form a gate of the transistor, a scan line, an electrode of a storage capacitor, and a second electrode of the discharge capacitor.

Preferred features of this aspect of the invention are set out in Claims 5 and 8.

### BRIEF DESCRIPTION OF THE DRAWINGS

These and/or other aspects and features of the invention will become apparent and more readily appreciated from the following description of embodiments thereof, taken in conjunction with the accompanying drawings of which:

FIG. 1 is a layout showing a part of a pixel region in a conventional organic light emitting display;

FIG. 2 is a cross-sectional view of the organic light emitting display taken along the line II - II' of FIG. 1;

FIG. 3 is a block diagram showing a construction of an organic light emitting display according to an embodiment of the present invention;

FIG. 4 is a layout showing a pixel region of the organic light emitting display shown in FIG. 3; and

FIG. 5 is a circuit diagram showing the pixel region shown in FIG. 4.

### DETAILED DESCRIPTION OF EXEMPLARY EMBODIMENTS

Hereinafter, embodiments of the present invention will be described with reference to the accompanying drawings. Here, when one element is described as being coupled to another element, the first element may be directly coupled to the second element, or may be indirectly coupled to the second element via another element. Further, some of the elements that are not essential for a complete understanding of the invention have been omitted for clarity. Also, like reference numerals refer to like elements throughout.

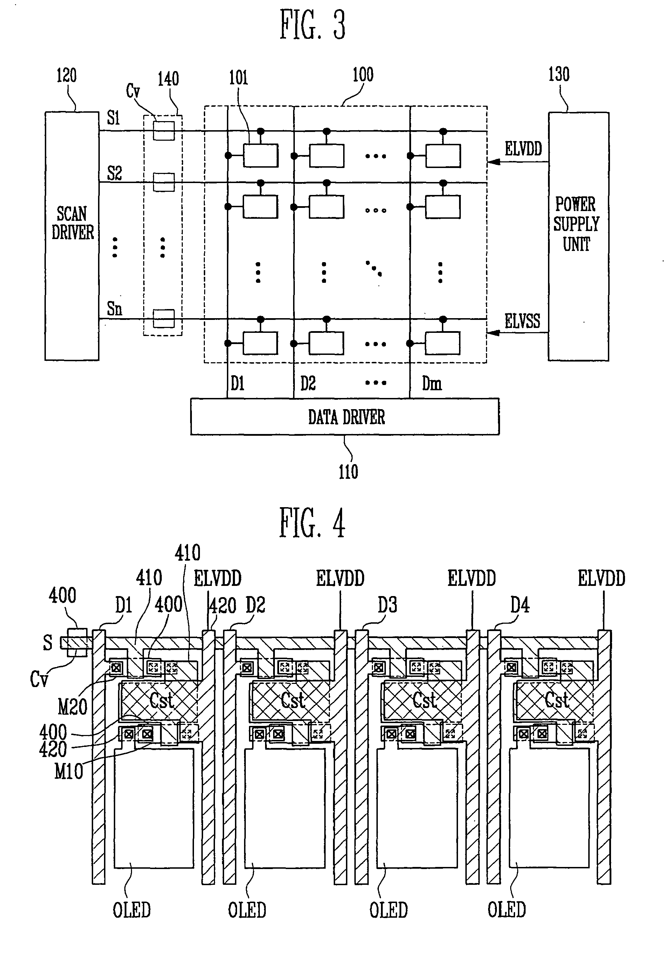

FIG. 3 is a block diagram showing a construction of an organic light emitting display according to one embodiment of the present invention. With reference to FIG. 3, the organic light emitting display according to this embodiment of the present invention includes a pixel region 100, a data driver 110, a scan driver 120, a power supply unit 130, and a discharge capacitor unit 140.

A plurality of pixels 101 is arranged at the pixel region 100. Each of the pixels 101 includes an organic light emitting diode (OLED), which emits light corresponding to a flow of an electric current. N scan lines S1,S2,...Sn-1,Sn are arranged in rows and transfer a scan signal. Further, m data lines D1, D2,....Dm-1, Dm are arranged in columns and transfer a data signal. Each of the pixels receives a first power source ELVDD and a second power source ELVSS from the power supply unit 130 and are driven accordingly thereto. Accordingly, in the pixel region 100, an OLED emits light by the scan signal, the data signal, the first power source ELVDD, and the second power source ELVSS to display images.

The data driver 110 applies the data signal to the pixel region 100. The data driver 110 receives video data of red, green, and blue components and generates the data signal. Further, the data driver 110 is coupled to the data lines D1, D2,....Dm-1, Dm of the pixel region 100, and applies the generated data signal to the pixel region 100.

The scan driver 120 applies a scan signal to the pixel region 100. The scan driver 120 is coupled to the scan lines S1,S2,...Sn-1,Sn, and transfers the scan signal to a specific row of the pixel region. A data signal outputted from the data driver 110 is transferred to the pixel 101 to which the scan signal is transferred. The data signal from the data driver 110 is applied to the specific row of the pixel region 100 to which the scan signal is transferred, so that an electric current corresponding to the data signal can flow through each pixel.

The power supply unit 130 transfers power by way of the first power source ELVDD and the second power source ELVSS to the pixel region 100. The power supply unit 130 receives power from the exterior, and generates the first power source ELVDD and the second power source ELVSS and transfers power from the power sources to the pixel region 100.

The discharge unit 140 has a construction in which capacitors Cv are coupled to each scan line. The discharge unit 140 is formed at a connection region of the scan driver 120 and the scan lines S1,S2,...Sn-1,Sn of the pixel region 100. When external static electricity is transferred to each capacitor of the discharge capacitor unit 140 through the scan lines S1,S2,...Sn-1,Sn, each capacitor Cv is charged with the static electricity and discharges the charge to reduce or prevent the static electricity from being transferred to each pixel 101 of the pixel region 100, thereby protecting the pixel 101. The width of the dielectric substance between the first electrode and the second electrode of each capacitor Cv of the discharge capacitor unit 140 is small. Accordingly, during a discharge event of the discharge capacitor unit 140, when static electricity of a high voltage is transferred to each capacitor Cv, the dielectric substance may be broken and receive the damage due to the static electricity to be transferred to the pixel 101 to protect the pixel 101. Further, when the scan driver 120 is coupled to the scan line, the coupling is formed at an inner part of the discharge capacitor unit 140. Accordingly, even when the discharge capacitor unit 140 is damaged due to static electricity, it has no trouble transferring the scan signal through the scan line.

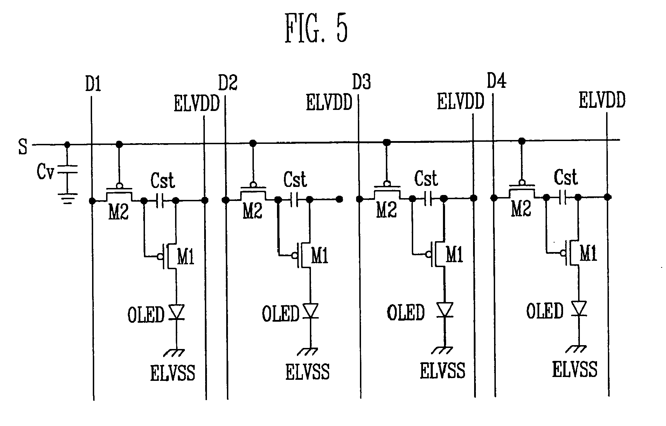

FIG. 4 is a layout showing a pixel region of the organic light emitting display shown in FIG. 3. FIG. 5 is a circuit diagram showing the pixel region shown in FIG. 4. With reference to FIG. 4 and FIG. 5, four pixels are arranged in the form of 4x 1, each having the same construction.

A poly-silicon layer 400 is formed on a region (e.g., a predetermined region) of a substrate. The poly-silicon layer becomes an active layer of a first transistor M10 and a second transistor M20, and a first electrode of a discharge capacitor unit. An insulation film (not shown) is formed on the poly-silicon layer 400, and gate electrodes (e.g., gate metals) 410 are formed on the insulation film. The gate electrodes (e.g., gate metals) 410 become gate electrodes of the first transistor M10 and the second transistor M20, a scan line S, and a first electrode of the storage capacitor Cst. An insulation film (not shown) is formed on the gate electrodes (e.g., gate metals) 410. A gate electrode (e.g., a gate metal) 410 among the gate electrodes (e.g., gate metals) 410 becoming the scan line S overlaps with the first electrode of a discharge capacitor Cv, and becomes a second electrode of the discharge capacitor Cv. Further, source-drain electrodes (e.g., source-drain metals) 420 are formed on the gate electrodes (e.g., gate metals) 410, and become source and drain electrodes of the first transistor M10 and the second transistor M20, a data line, a power supply line, and a second electrode of the storage capacitor Cst. Organic light emitting diodes OLED are formed at regions (e.g., predetermined regions) on the source-drain electrodes (e.g., source-drain metals) 420. Consequently, a discharge capacitor Cv is made to protect the pixel.

In the organic light emitting display and a method for manufacturing the same according to an embodiment of the present invention, a static electricity prevention structure is added to reduce or prevent damage caused by static electricity. This may prevent a pixel from being damaged due to a static electricity event occurring during the manufacturing procedure, thereby increasing the yield of the organic light emitting display.

Although embodiments of the present invention have been shown and described, it should be appreciated by those skilled in the art that changes might be made to these embodiments without departing from the principles of the invention, the scope of which is defined in the claims and their equivalents.

## Claims

1. An organic light emitting display comprising:
a pixel region including a plurality of data lines, a plurality of scan lines, and a plurality of pixels, the plurality of data lines crossing the plurality of scan lines, and the pixels being coupled to the data lines and the scan lines;
a data driver coupled to the data lines for transferring a data signal;
a scan driver coupled to the scan lines for transferring a scan signal; and
a discharge capacitor unit at a connection region between the pixel region and the scan driver.

2. An organic light emitting display as claimed in claim 1, wherein at least one of the pixels comprises:
a poly-silicon layer patterned on the pixel region;
a first insulation film on the poly-silicon layer;
a gate electrode on the first insulation film and coupled to the scan lines;
a second insulation film on the gate electrode; and
a source-drain electrode contacting with the poly-silicon layer through a contact hole.

3. An organic light emitting display as claimed in claim 2, wherein the discharge capacitor unit comprises:
a plurality of discharge capacitors comprising at least one discharge capacitor for each of the scan lines,
wherein a first electrode of each discharge capacitor comprises a portion of the poly-silicon layer at a periphery of the pixel region, and
wherein a second electrode of each discharge capacitor comprises a portion of a corresponding one of the scan lines overlapping the portion of the poly-silicon layer.

4. A method for manufacturing an organic light emitting display, the method comprising:
forming a poly-silicon layer on a substrate to form a first electrode of a discharge capacitor when an active layer of a transistor is formed; and
forming a metal layer to form a gate of the transistor, a scan line, an electrode of a storage capacitor, and a second electrode of the discharge capacitor.

5. A method as claimed in claim 4, wherein the discharge capacitor is at a region adjacent to a scan driver for transferring a scan signal.

6. A method as claimed in claim 4 or 5, wherein the first electrode of the discharge capacitor comprises a portion of the poly-silicon layer at a periphery of the pixel region, and the second electrode of the discharge capacitor comprises a portion of the scan line overlapping the portion of the poly-silicon layer.
